# EUROPÄISCHE PATENTSCHRIFT

(11) **EP 1 218 755 B1**
(45) Veröffentlichungstag und Bekanntmachung des Hinweises auf die Patenterteilung: **31.08.2005**
(21) Anmeldenummer: 00988658.1
(22) Anmeldetag: 25.11.2000
(51) Int. Cl.: G01P 15/08

(54) **MIKROMECHANISCHE FEDERSTRUKTUR, INSBESONDERE FÜR EINEN DREHRATENSENSOR**
MICROMECHANICAL SPRING STRUCTURE, ESPECIALLY FOR A ROTATIONAL SPEED SENSOR
STRUCTURE OSCILLANTE MICROMECANIQUE, EN PARTICULIER POUR UN CAPTEUR DE VITESSE DE ROTATION

(30) Priorität: 16.12.1999 DE 19960604
(43) Veröffentlichungstag der Anmeldung: 03.07.2002
(73) Patentinhaber: ROBERT BOSCH GMBH, 70442 Stuttgart (DE)
(72) Erfinder: KIPP, Andreas, 72766 Reutlingen (DE); HAUER, Joerg, 72762 Reutlingen (DE); GOETZ, Siegbert, 70839 Gerlingen (DE); LUTZ, Markus, Sunnyvale, CA 94086 (DE)
(86) Internationale Anmeldenummer: PCT/DE2000/004193
(87) Internationale Veröffentlichungsnummer: WO 2001/044823

(56) Entgegenhaltungen:
- DE-A- 19 719 601
- DE-A- 19 817 357
- GB-A- 2 192 718
- US-A- 5 631 422

## Beschreibung

Die vorliegende Erfindung betrifft eine mikromechanische Federstruktur, insbesondere für einen Drehratensensor, mit einem ersten und einem zweiten zusammenwirkenden Federbalken, welche streckenweise im wesentlichen parallel zueinander verlaufen und streckenweise aneinander gekoppelt sind.

Obwohl auf beliebige mikromechanische Federstrukturen anwendbar, werden die vorliegende Erfindung und die ihr zugrundeliegende Problematik in bezug auf einen mikromechanischen Drehratensensor erläutert.

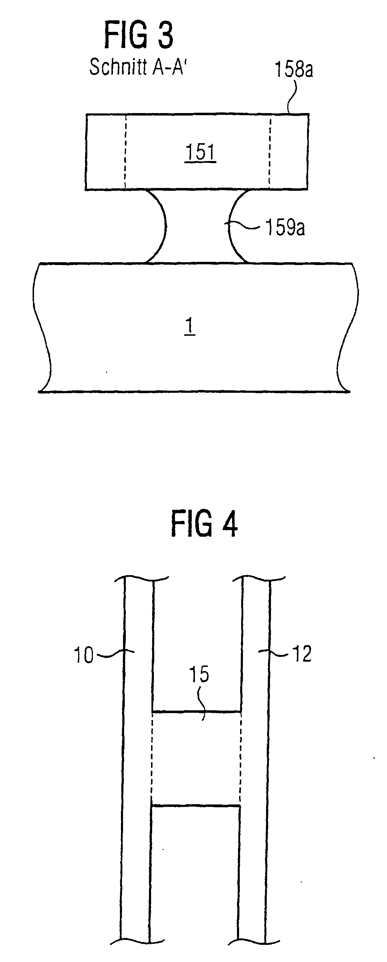

Fig. 4 zeigt eine schematische Draufsicht auf eine bekannte mikromechanische Federstruktur für einen Drehratensensor.

In Figur 4 bezeichnen 10 einen ersten Federbalken und 12 einen zweiten Federbalken. 15 ist ein Verbindungsbereich, in dem der erste und zweite Federbalken 10, 12 aneinander gekoppelt sind.

Die derart aufgebaute bekannte mikromechanische Federstruktur weist den wesentlichen Nachteil auf, dass bei stärkeren Krümmungen im Bereich des Verbindungsbereichs 15 Spannungsspitzen an den im wesentlichen rechtwinkligen Übergängen zwischen den Federbalken 10, 12 und dem Verbindungsbereich 15 auftreten. Dies führt im ungünstigsten Fall zu Rissen oder zur vollständigen Zerstörung des Verbindungsbereichs 15.
Aus der DE-A-198 17 357 ist eine Struktur mit zwei Federbalken und einem Verbindungsbereich bekannt. Der Verbindungsbereich verläuft im wesentlichen rechtwinklig zu den Federbalken.

### VORTEILE DER ERFINDUNG

Die der vorliegenden Erfindung gemäß Anspurch 1 zugrundeliegende Idee liegt in einer besonderen Ausgestaltung der Federgeometrie. Insbesondere weisen der erste und zweite Federbalken einen gemeinsamen Krümmungsbereich auf, in dem sie aneinander durch einen Verbindungsbereich gekoppelt sind. Ein zwischen dem ersten und zweiten Federbalken liegender erster Übergangsbereich verläuft zum Verbindungsbereich im wesentlichen krümmungsstetig. Krümmungsbereich bedeutet in diesem Zusammenhang, daß in diesem Bereich entweder ständig eine Krümmung vorliegt oder eine Krümmung dort beim Betrieb auftritt.

Diese Art der Geometrie weist den Vorteil auf, daß die Spannungen im Verbindungsbereich minimiert sind, so daß Beschädigungen im wesentlichen dort nicht auftreten können.

In den Unteransprüchen finden sich vorteilhafte Weiterbildungen und Verbesserungen der in Anspruch 1 angegebenen mikromechanischen Federstruktur.

Gemäß einer bevorzugten Weiterbildung weisen der erste und zweite Federbalken einen in den ersten Übergangsbereich übergehenden ersten Verbreiterungsbereich auf. Dies hat den Vorteil, daß die auftretenden Spannungen weiter erniedrigt werden.

Gemäß einer weiteren bevorzugten Weiterbildung verschmälert sich der erste Verbreiterungsbereich im wesentlichen linear oder trapezoidal mit zunehmender Entfernung vom ersten Übergangsbereich. Dies hat den Vorteil, daß die Spannungswerte in Betriebsrichtung und für die Fallfestigkeit gering gehalten werden. Der erzielbare Effekt ist eine Verteilung der Spannungen und eine deutliche Reduktion des Spannungsmaximums.

Gemäß einer weiteren bevorzugten Weiterbildung sind der erste und zweite Federbalken an einen mit einem Substrat verbundenen Festlandbereich oder an einen über dem Substrat schwebenden Inselbereich angeschlossen. Ein zweiter Übergangsbereich zum Festlandbereich oder Inselbereich verläuft im wesentlichen krümmungsstetig. Glatte bzw. krümmunasstetige Übergänge bei der Anbindung ans Festland bzw. an die Insel sollten ebenfalls verhindern, dass dort Spannungsspitzen auftreten.

Gemäß einer weiteren bevorzugten Weiterbildung weisen der erste und zweite Federbalken einen in den zweiten Übergangsbereich übergehenden zweiten Verbreiterungsbereich auf. Dies hat den Vorteil, daß die auftretenden Spannungen weiter erniedrigt werden.

Gemäß einer weiteren bevorzugten Weiterbildung verschmälert sich der zweite Verbreiterungsbereich im wesentlichen linear oder trapezoidal mit zunehmender Entfernung vom Übergangsbereich. Dies hat den Vorteil, daß die Spannungswerte in Betriebsrichtung und für die Fallfestigkeit gering gehalten werden.

Gemäß einer weiteren bevorzugten Weiterbildung weist mindestens einer vom ersten und zweiten Federbalken einen vorzugsweise kreisförmigen dritten Verbreiterungsbereich auf, der einen zentralen Befestigungsbereich zur Befestigung am Substrat hat. Dies ist eine vorteilhafte Art der Ankopplung zur Eigenfrequenzunterdrückung mit entsprechender Fertigungssicherheit beim Gasphasenätzen.

Gemäß einer weiteren bevorzugten Weiterbildung weisen der erste und zweite Federbalken eine Doppel-U-Struktur auf und der Verbindungsbereich in der Doppel-U-Krümmung liegt. Diese Struktur weist eine günstige Symmetrie auf. Die Doppel - U - Federform ist günstig, um zwei gegeneinander isolierte Leiterbahnen gleicher Breite auf den Federbalken führen zu können. Bei einer einfachen U - Feder müsste die Federbalkenstruktur mindestens doppelt so breit sein und damit mindestens doppelt so lang sein, um die gleiche Steifigkeit zu erreichen. Die Chipfläche wird also immer deutlich kleiner bei Realisierung einer Doppel - U - Feder. Die beiden Federbalken sind in der U - Rundung mechanisch verbunden, damit es keinen Beschleunigungsanteil bei resonantem Betrieb orthogonal zur Schwingungsrichtung gibt.

Solch ein Beschleunigungsanteil würde in Detektionsrichtung eines die Federstruktur verwendenden Coriolis-Drehratensensors wirken und somit eine Quadratur erzeugen, d.h. ein Störsignal in der Ausgangsspannung. Die Verbindung kann bei diesem Beispiel so ausgelegt werden, dass die auftretenden Spannungen in Bewegungsrichtung und in z-Richtung möglichst klein sind.

Gemäß einer weiteren bevorzugten Weiterbildung sind auf dem ersten und zweiten Federbalken eine erste und zweite Leiterbahneinrichtung aufgebracht. So lassen sich zwei Leiterbahnen gleicher Breite effektiv voneinander isolieren bzw. trennen.

Gemäß einer weiteren bevorzugten Weiterbildung ist sie durch Silizium-Oberflächenmikromechanik bzw. Silizium-Oberflächenmikromechanik in Verbindung mit Silizium-Bulkmikromechanik oder eine andere Mikromechanik-Technologie herstellbar.

### ZEICHNUNGEN

Ein Ausführungsbeispiel der Erfindung ist in den Zeichnungen dargestellt und in der nachfolgenden Beschreibung näher erläutert.

Es zeigen:
- Fig. 1: eine schematische Draufsicht auf eine Ausführungsform der erfindungsgemäßen mikromechanischen Federstruktur als Teil eines Drehratensensors;
- Fig. 2: eine Ausschnittsvergrößerung von Fig. 1 im Bereich V;
- Fig. 3: einen Querschnitt von Fig. 1 entlang der Linie A-A'; und
- Fig. 4: eine schematische Draufsicht auf eine bekannte mikromechanische Federstruktur.

### BESCHREIBUNG DER AUSFÜHRUNGSBEISPIELE

In den Figuren bezeichnen gleiche Bezugszeichen gleiche oder funktionsgleiche Bestandteile.

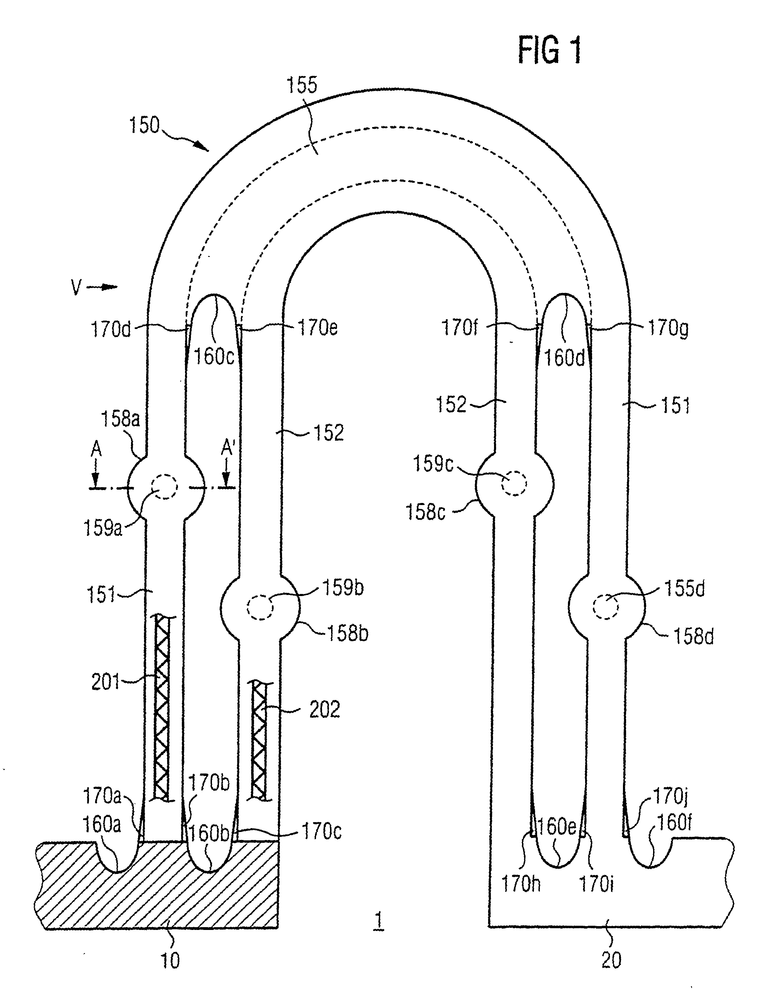

Fig. 1 zeigt eine schematische Draufsicht auf eine Ausführungsform der erfindungsgemäßen mikromechanischen Federstruktur als Teil eines Drehratensensors.

In Figur 1 bezeichnen 151 einen ersten Federbalken und 152 einen zweiten Federbalken, welche eine Doppel-U-Struktur aufweisen. Der erste und zweite Federbalken 151, 152 weisen den gemeinsamen U-Krümmungsbereich 150 auf und sind dort durch einen speziellen Verbindungsbereich 155 aneinander gekoppelt. Mit anderen Worten ist der Verbindungsbereich 155 eine durchgehende Brücke zwischen den beiden Federbalken 151, 152. Die beiden Federbalken 151, 152 verbinden einen mit einem Substrat 1 verbundenen Festlandbereich 10 mit einem über dem Substrat 1 schwebenden Inselbereich 20. Auf dem ersten und zweiten Federbalken 151, 152 ist eine erste bzw. zweite Leiterbahneinrichtung 201, 202 isoliert zueinander aufgebracht.

160c und 160d bezeichnen einen jeweiligen ersten halbkreisförmigen Übergangsbereich zwischen dem ersten und zweiten Federbalken 151, 152 und dem Verbindungsbereich 155. Dieser Übergangsbereich 160c, 160d verläuft im wesentlichen krümmunasstetig. Dies bedeutet, dass die Krümmung gleichmäßig zunimmt bzw. abnimmt, und nicht einen Sprung aufweist, wie dies beispielsweise durch den rechten Winkel gemäß der Struktur von Figur 4 der Fall ist. Hierdurch lassen sich Spannungsspitzen abbauen.

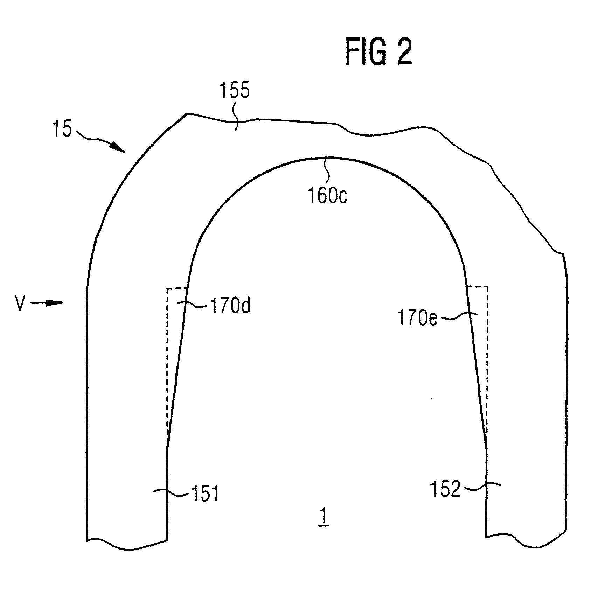

Wie aus Figur 1 und der Ausschnittsvergrößerung des Bereichs V gemäß Figur 2 ersichtlich ist, ist an den Enden des ersten und zweiten Federbalkens 151, 152 ein jeweiliger Verbreiterungsbereich 170d, 170e bzw. 170f, 170g vorgesehen, welcher ebenfalls im wesentlichen krümmungsstetig in den ersten Übergangsbereich 160c bzw. 160d verläuft. Bei dieser ersten Ausführungsform verläuft der erste Verbreiterungsbereich 170d, 170e bzw. 170f, 170g im wesentlichen linear in den jeweiligen Federbalken 151 bzw. 152 über. Mit anderen Worten verschmälert er sich linear.

Ein entsprechender zweiter halbkreisförmiger Übergangsbereich 160a, 160b bzw. 160e, 160f ist am Festlandbereich 10 bzw. am Inselbereich 20 vorgesehen. Hier laufen die Federbalken 151 bzw. 152 krümmungsstetig in den Festlandbereich 10 bzw. den Inselbereich 20 über. Analog wie am Verbindungsbereich 155 ist auch hier ein Verbreiterungsbereich 170a, 170b, 170c, 170h, 170i, 170j vorgesehen, der sich im wesentlichen linear mit zunehmender Entfernung vom Übergangsbereich 160a, 160b bzw. 160e, 160f verschmälert. Somit ist es möglich, auch an diesen Orten die Spannungsspitzen zu minimieren. Dies ist ohnehin dort der Fall, wo die Federbalken geradlinig in den Festlandbereich 10 bzw. in den Inselbereich 20 übergehen, also an den Innenseiten der Doppel-U-Struktur.

Die beiden Federbalken 151, 152 weisen weiterhin einen jeweiligen kreisförmigen dritten Verbreiterungsbereich 158a bis d auf, welcher einen zentralen Befestigungsbereich 159a bis d zur Befestigung am Substrat aufweist, wie in Figur 3, welche einen Schnitt entlang der Linie A-A' in Figur 1 bezeichnet, näher illustriert.

Die mikromechanische Federstruktur gemäß diesem Ausführungsbeispiel ist für einen bekannten Drehratensensor gedacht, in dem nach dem Coriolis-Prinzip eine Drehrate in eine lineare Beschleunigung umgewandelt wird.

Die Herstellung der in Figur 1 bis 3 illustrierten mikromechanischen Federstruktur geschieht mittels Silizium-Oberflächenmechanik in Verbindung mit Silizium-Bulkmikromechanik. Prinzipiell wird dazu auf dem Siliziumsubstrat 1 eine Siliziumdioxid-Opferschicht vorgesehen, auf der wiederum epitaktisch eine Polysiliziumschicht abgeschieden wird.

Die Federstruktur wird dann mittels eines Trench/Grabenätzprozesses ausgebildet, und danach wird die Siliziumdioxid-Opferschicht mittels eines Ätzprozesses dort entfernt, wo das Polysilizium freibeweglich gegenüber dem Substrat 1 sein soll.

Gemäß Figur 1 verbindet die mikromechanische Federstruktur aus Polysilizium den ebenfalls aus Polysilizium bestehenden Festlandbereich 10, welcher über die Siliziumdioxid-Opferschicht mit einem Substrat 1 verbunden ist, mit dem ebenfalls aus Polysilizium bestehenden Inselbereich 20, welcher mit dem Substrat 1 fest verbunden, aber frei beweglich ist.

Für die Gewährleistung der mechanischen Anbindung zwischen dem Substrat und dem epitaxierten Polysilizium ist es notwendig, daß das Siliziumdioxid mit einer definierten Angriffsfläche am Substrat und am epitaxierten Polysilizium erhalten bleibt. Das vorgestellte Design erfüllt diese Anforderung an den kreisförmigen Verbreiterungen und im Verbindungsbereich 155 zur Verbindung der Doppel-U-Bögen.

Die Basis für die konkrete Auslegung der Federbalken können Finite-Elemente-Simulationen bilden, welche die betrachteten mechanischen Sachverhalte sehr gut beschreiben können. Anhand von Mustern konnte nachgewiesen werden, dass die erfindungsgemäße Federstruktur eine mechanisch stabile Anbindung zwischen dem Substrat und dem epitaxierten Polysilizium gewährleistet.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Insbesondere ist die Geometrie der Federstruktur nicht auf die gezeigten Beispiele beschränkt. Allerdings sollten größere Abweichungen von der symmetrischen Form dann vermieden werden, wenn die Gefahr besteht, daß lineare Anteile der externen Beschleunigung das Meßergebnis verfälschen.

Das Herstellungsverfahrens ist ebenfalls nur als Beispiel zu verstehen, und andere Verfahren, wie z.B. galvanische Verfahren, können ebenfalls zu Herstellung der mikromechanischen Federstruktur verwendet werden.

## Patentansprüche

1. Mikromechanische Federstruktur, insbesondere für einen Drehratensensor, mit:
einem ersten und einem zweiten zusammenwirkenden Federbalken (151, 152), welche streckenweise im wesentlichen parallel zueinander verlaufen und streckenweise aneinander gekoppelt sind;
**dadurch gekennzeichnet , daß**
der erste und zweite Federbalken (151, 152) einen gemeinsamen Krümmungsbereich (150) aufweisen, in dem sie aneinander durch einen Verbindungsbereich (155) gekoppelt sind; und
ein zwischen dem ersten und zweiten Federbalken (151, 152) liegender erster Übergangsbereich (160c; 160d) zum Verbindungsbereich (155) im wesentlichen krümmungsstetig verläuft.

2. Mikromechanische Federstruktur nach Anspruch 1, **dadurch gekennzeichnet, daß** der erste und zweite Federbalken (151, 152) einen in den ersten Übergangsbereich (160c, 160d) übergehenden ersten Verbreiterungsbereich (170d, 170e; 170f, 170g) aufweisen.

3. Mikromechanische Federstruktur nach Anspruch 2, **dadurch gekennzeichnet, daß** sich der erste Verbreiterungsbereich (170d, 170e; 170f, 170g) im wesentlichen linear oder trapezoidal mit zunehmender Entfernung vom ersten Übergangsbereich (160c, 160d) verschmälert.

4. Mikromechanische Federstruktur nach Anspruch 3, **dadurch gekennzeichnet, daß** der erste und zweite Federbalken (151, 152) an einen mit einem Substrat (1) verbundenen Festlandbereich (10) oder an einen über dem Substrat (1) schwebenden Inselbereich (20) angeschlossen sind; und ein zweiter Übergangsbereich (160a; 160b; 160e; 160f) zum Festlandbereich (10) oder Inselbereich (20) im wesentlichen krümmungsstetig verläuft.

5. Mikromechanische Federstruktur nach Anspruch 5, **dadurch gekennzeichnet, daß** der erste und zweite Federbalken (151, 152) einen in den zweiten Übergangsbereich (160a; 160b; 160e; 160f) übergehenden zweiten Verbreiterungsbereich (170a, 170b; 170c; 170h, 170i; 170j) aufweisen.

6. Mikromechanische Federstruktur nach Anspruch 5, **dadurch gekennzeichnet, daß** sich der zweite Verbreiterungsbereich (170a, 170b; 170c; 170h, 170i; 170j) im wesentlichen linear oder trapezoidal mit zunehmender Entfernung vom Übergangsbereich (160a; 160b; 160e; 160f) verschmälert.

7. Mikromechanische Federstruktur nach einem der vorhergehenden Ansprüche, **dadurch gekennzeichnet, daß** mindestens einer vom ersten und zweiten Federbalken (151, 152) einen vorzugsweise kreisförmigen dritten Verbreiterungsbereich (158a-d) aufweist, der einen zentralen Befestigungsbereich (159a-d) zur Befestigung am Substrat (1) hat.

8. Mikromechanische Federstruktur nach einem der vorhergehenden Ansprüche, **dadurch gekennzeichnet, daß** der erste und zweite Federbalken (151, 152) eine Doppel-U-Struktur aufweisen und der Verbindungsbereich (155) in der Doppel-U-Krümmung liegt.

9. Mikromechanische Federstruktur nach einem der vorhergehenden Ansprüche, **dadurch gekennzeichnet, daß** auf dem ersten und zweiten Federbalken (151, 152) eine erste und zweite Leiterbahneinrichtung (201, 202) aufgebracht sind.

10. Mikromechanische Federstruktur nach einem der vorhergehenden Ansprüche, **dadurch gekennzeichnet, daß** sie durch Silizium-Oberflächenmikromechanik oder eine andere Mikromechanik-Technologie herstellbar ist.

## Claims

1. Micromechanical spring structure, in particular for a rotation rate sensor, having:
a first and a second interacting spring bar (151, 152) which, in places, run essentially parallel to one another and are coupled to one another in places;
**characterized in that**
the first and the second spring bar (151, 152) have a common curvature area (150) in which they are coupled to one another by means of a connecting area (155); and
a first transitional area (160c; 160d), which is located between the first and the second spring bars (151, 152), runs essentially with continuous curvature to the connecting area (155).

2. Micromechanical spring structure according to Claim 1, **characterized in that** the first and the second spring bars (151, 152) have a first broadening area (170d, 170e; 170f, 170g) which merges into the first transitional area (160c, 160d).

3. Micromechanical spring structure according to Claim 2, **characterized in that** the first broadening area (170d, 170e; 170f, 170g) narrows essentially linearly or trapezoidally as the distance from the first transitional area (160c, 160d) increases.

4. Micromechanical spring structure according to Claim 3, **characterized in that** the first and the second spring bars (151, 152) are connected to a fixed land area (10) which is connected to a substrate (1) or to an island area (20), which floats above the substrate (1); and a second transitional area (160a; 160b; 160e; 160f) runs with essentially continuous curvature to the fixed land area (10) or island area (20).

5. Micromechanical spring structure according to Claim 5, **characterized in that** the first and the second spring bars (151, 152) have a second broadening area (170a, 170b; 170c; 170h, 170i; 170j) which merges into the second transitional area (160a; 160b; 160e; 160f).

6. Micromechanical spring structure according to Claim 5, **characterized in that** the second broadening area (170a, 170b; 170c; 170h, 170i; 170j) narrows essentially linearly or trapezoidally as the distance from the transitional area (160a; 160b; 160e; 160f) increases.

7. Micromechanical spring structure according to one of the preceding claims, **characterized in that** at least one of the first and second spring bars (151, 152) has a preferably circular third broadening area (158a-d), which has a central attachment area (159a-d) for attachment to the substrate (1).

8. Micromechanical spring structure according to one of the preceding claims, **characterized in that** the first and the second spring bars (151, 152) have a double-U structure, and the connecting area (155) is located in the double-U curvature.

9. Micromechanical spring structure according to one of the preceding claims, **characterized in that** a first and a second conductor track device (201, 202) are fitted to the first and the second spring bars (151, 152).

10. Micromechanical spring structure according to one of the preceding claims, **characterized in that** the micromechanical spring structure can be produced by silicon surface micromechanics, or by some other micromechanical technology.

## Revendications

1. Structure de ressort micromécanique notamment pour un capteur de vitesse de rotation comprenant
un premier et un second ressort-tige (151, 152) qui coopèrent, et par tronçons ils sont au moins essentiellement parallèles et par tronçons, ils sont découplés l'un de l'autre,
**caractérisée en ce que**
le premier et le second ressort-tige (151, 152) ont une zone de courbure (150) commune dans laquelle les tiges sont reliées par une zone de liaison (155), et
une première zone de transition (160c, 160d) située entre le premier et le second ressort-tige (151, 152) vers la zone de liaison (155) présente une courbure essentiellement continue.

2. Structure de ressort micromécanique selon la revendication 1,
**caractérisée en ce que**
le premier et le second ressort-tige (151, 152) ont une première zone élargie (170d, 170e ; 170f, 170g) qui rejoint la première zone de transition (160c, 160d).

3. Structure de ressort micromécanique selon la revendication 2,
**caractérisée en ce que**
la première zone élargie (170d, 170e ; 170f, 170g) se rétrécit d'une manière essentiellement linéaire ou trapézoïdale en s'éloignant de manière croissante de la première zone de transition (160c, 160d).

4. Structure de ressort micromécanique selon la revendication 3,
**caractérisée en ce que**
le premier et le second ressort-tige (151, 152) sont reliés à une zone immobile (10) reliée à un substrat (1) ou à une zone d'îlot (20) flottant au-dessus du substrat (1) et une seconde zone de transition (160a ; 160b ; 160e ; 160f) rejoint la zone fixe (10) ou la zone d'îlot (20) essentiellement selon une courbure constante.

5. Structure de ressort micromécanique selon la revendication 4,
**caractérisée en ce que**
le premier et le second ressort-tige (151, 152) ont une seconde zone élargie (170a, 170b ; 170c ; 170h, 170i ; 170j) rejoignant la seconde zone de transition (160a ; 160b ; 160e ; 160f).

6. Structure de ressort micromécanique selon la revendication 5,
**caractérisée en ce que**
la seconde zone élargie (170a, 170b ; 170c ; 170h, 170i ; 170j) se rétrécit d'une manière essentiellement linéaire ou trapézoïdale en fonction de l'éloignement par rapport à la zone de transition (160a ; 160b ; 160e ; 160f).

7. Structure de ressort micromécanique selon l'une des revendications précédentes,
**caractérisée en ce qu'**
au moins l'un des premier et second ressort-tige (151, 152) présente une troisième zone d'extension (158a-d), de préférence circulaire, ayant une zone de fixation centrale (159a-d) pour être fixée au substrat (1).

8. Structure de ressort micromécanique selon l'une des revendications précédentes,
**caractérisée en ce que**
le premier et le second ressort-tige (151, 152) ont une structure en forme de double U et la zone de liaison (155) se situe dans la courbure du double U.

9. Structure de ressort micromécanique selon l'une des revendications précédentes,
**caractérisée en ce qu'**
une première et une seconde installation de chemin conducteur (201, 202) sont prévues sur le premier et le second ressort-tige (151, 152).

10. Structure de ressort micromécanique selon l'une des revendications précédentes,
**caractérisée en ce qu'**
elle est réalisée en micromécanique de surface de silicium ou une autre technique de micromécanique.
